(19) Europäisches Patentamt / European Patent Office / Office européen des brevets

(11) **EP 4 157 665 B1**

(12) **FASCICULE DE BREVET EUROPEEN**

(45) Date de publication et mention de la délivrance du brevet:
**15.01.2025 Bulletin 2025/03**

(21) Numéro de dépôt: **21732378.1**

(22) Date de dépôt: **25.03.2021**

(51) Classification Internationale des Brevets (IPC):
**B60L 3/12** *(2006.01)*    **H01M 10/48** *(2006.01)*
**B60L 53/65** *(2019.01)*    **B60L 58/12** *(2019.01)*
**H01M 10/44** *(2006.01)*    **B60L 58/16** *(2019.01)*
**G01R 31/367** *(2019.01)*    **G01R 31/387** *(2019.01)*
**G01R 31/392** *(2019.01)*    **G01R 31/382** *(2019.01)*

(52) Classification Coopérative des Brevets (CPC):
**B60L 53/65; B60L 3/12; B60L 53/665; B60L 58/12; B60L 58/16; G01R 31/367; G01R 31/382; H01M 10/44; H01M 10/48;** B60L 2240/70; B60L 2260/42; B60L 2260/44; H01M 2220/20; Y02E 60/10; Y02T 10/70;     (Cont.)

(86) Numéro de dépôt international:
**PCT/FR2021/050526**

(87) Numéro de publication internationale:
**WO 2021/240075 (02.12.2021 Gazette 2021/48)**

(54) **PROCÉDÉ D'ESTIMATION DE L'ÉTAT DE CHARGE D'UNE BATTERIE ÉLECTRIQUE NOTAMMENT POUR LA GESTION ÉNERGÉTIQUE DE RECHARGE DES VÉHICULES ÉLECTRIFIÉS**

VERFAHREN ZUR ABSCHÄTZUNG DES LADEZUSTANDS EINER BATTERIE INSBESONDERE ZUR WIEDERAUFLADENSVERWALTUNG VON ELEKTROFAHRZEUGEN

METHOD FOR STATE OF CHARGE ESTIMATION OF A BATTERY IN PARTICULAR FOR RECHARGE MANAGEMENT OF ELECTRIC VEHICLES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.05.2020 FR 2005535**

(43) Date de publication de la demande:
**05.04.2023 Bulletin 2023/14**

(73) Titulaire: **Stellantis Auto SAS**
**78300 Poissy (FR)**

(72) Inventeurs:
- **BAGHDADI, Issam**
  **78600 Le Mesnil Le Roi (FR)**
- **PETIT, Benjamin**
  **92500 Rueil Malmaison (FR)**
- **MERVEILLAUT, Mathieu**
  **78210 St Cyr L' Ecole (FR)**

(74) Mandataire: **PSIP**
**Stellantis**
**Service REIP**
**Propriété industrielle - YT800**
**2-10, boulevard de l'Europe**
**78300 Poissy (FR)**

(56) Documents cités:
EP-A1- 3 587 171    DE-A1- 102011 107 055
US-A1- 2013 320 989    US-A1- 2014 266 227
US-A1- 2017 225 584    US-A1- 2017 267 116

(52) Classification Coopérative des Brevets (CPC):
(Cont.)Y02T 10/7072; Y02T 10/72; Y02T 90/12;
Y02T 90/16; Y02T 90/167; Y04S 30/14

**Description**

La présente invention revendique la priorité de la demande française N°2005535 déposée le 26.05.2020.

L'invention concerne de manière générale la recharge électrique des batteries électriques des véhicules électrifiés, comme les véhicules hybrides rechargeables et les véhicules électriques. Plus particulièrement, l'invention se rapporte à un procédé d'estimation de l'état de charge d'une batterie électrique notamment pour la gestion énergétique de la recharge d'un véhicule électrifié.

Les infrastructures de recharge électrique des véhicules électrifiés sont pensées dans le cadre des futurs réseaux intelligents de transport d'énergie électrique, dit « Smart Grid » en anglais, de manière à optimiser le bilan énergétique et la disponibilité des véhicules électrifiés, et à réduire leur empreinte carbone. Dans le contexte d'un réseau électrique intelligent, les équipements de recharge embarqués dans le véhicule doivent être réversibles afin de permettre au réseau, non seulement de fournir l'énergie électrique pour la recharge de la batterie électrique de traction du véhicule, mais aussi, dans un mode dit « V2G », de puiser de l'énergie disponible dans celle-ci pour répondre à une forte demande, par exemple, lors d'une pointe de consommation électrique. La recharge électrique des véhicules électrifiés fait intervenir essentiellement les convertisseurs électriques embarqués dans les véhicules, un parc déployé de bornes de recharge électrique, un système de gestion énergétique, un fournisseur ou agrégateur d'énergie électrique et des réseaux de communication de données tels que le réseau Internet et le réseau de radiotéléphonie cellulaire ou autres.

La gestion intelligente de la recharge d'un véhicule électrifié est une opération discontinue dans le temps qui assure un étalement de la recharge électrique notamment en fonction de différents objectifs et contraintes liés par exemple à une disponibilité énergétique, un mode « V2G » ou autres.

La discontinuité du processus de recharge de la batterie électrique conduit à une sollicitation importante de plusieurs composants de l'électronique embarquée du véhicule électrifié, sollicitation importante qui peut provoquer un vieillissement prématuré de ces composants. Ainsi, lors du démarrage d'une session de recharge électrique de la batterie électrique du véhicule ou avant chaque reprise de la recharge après des interruptions de celles-ci, le système de gestion énergétique a besoin notamment de connaître l'état de charge de la batterie électrique et sollicite pour cela le véhicule à travers son module télématique embarqué. L'utilisateur du véhicule peut également à travers une application logicielle installée dans son téléphone intelligent, dit « smartphone », solliciter plusieurs fois le véhicule pour connaître l'avancement de la recharge de la batterie électrique de son véhicule.

Il résulte de toutes ces sollicitations, une multitude d'opérations répétitives de réveil/endormissement de différents composants d'électronique embarquée du véhicule pour récupérer de l'information et la transmettre au demandeur, c'est-à-dire, au système de gestion énergétique ou à l'utilisateur du véhicule. Le module télématique embarqué et l'antenne intelligente qui lui est associée, ainsi que le module de gestion de batterie électrique dit « BMS », le module superviseur de véhicule dit « VSM », et l'unité de contrôle véhicule dit « VCU » sont les composants d'électronique embarquée du véhicule principalement sollicités pour la lecture de l'état de charge de la batterie électrique.

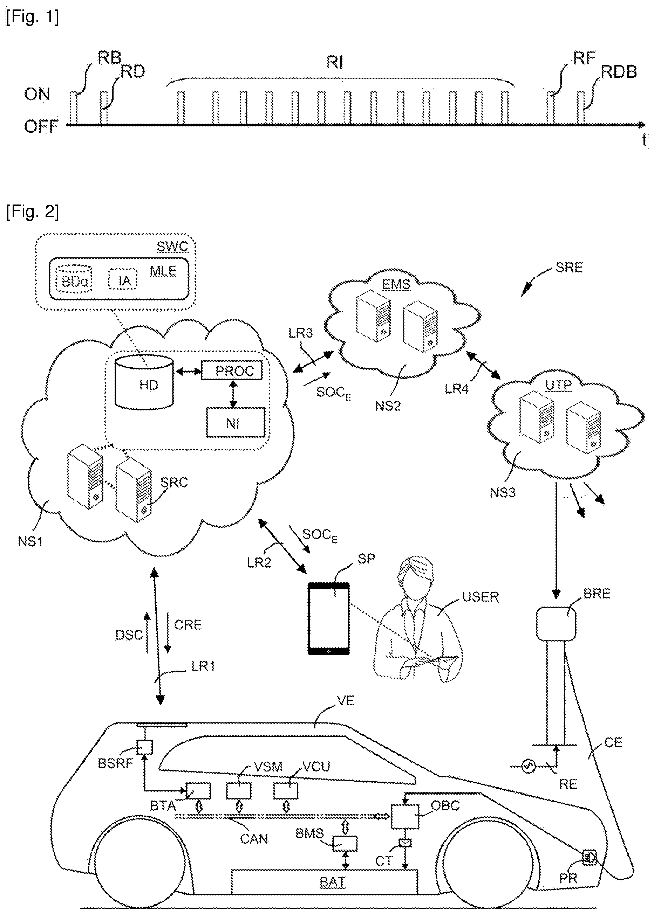

La Fig.1 montre à titre d'exemple une séquence d'opérations de réveil/endormissement du module télématique embarqué et de l'antenne intelligente pendant une session de recharge électrique de la batterie électrique du véhicule, les états « ON » et « OFF » représentant respectivement le réveil et l'endormissement de ces équipements. Une multitude de réveils RI interviennent entre des réveils de début RD et de fin RF de la session de recharge électrique. Le branchement du câble électrique de recharge sur le véhicule provoque un premier réveil RB des équipements. Le débranchement du câble électrique de recharge du véhicule provoque un dernier réveil RDB des équipements.

Le module télématique et l'antenne intelligente du véhicule sont conçus pour un certain nombre de réveils par jour, par exemple, une à deux dizaines de réveils par jour. Un nombre important de réveils par rapport à ce nombre de réveils journalier, dus par exemple à un utilisateur anxieux qui consulte répétitivement l'état de charge de la batterie électrique, peut conduire à des défaillances et une moindre durabilité de ces équipements embarqués.

Par le document FR3041782A1, il est connu un procédé de gestion du réveil d'un calculateur dans un véhicule connecté à une borne de recharge électrique. Dans ce procédé, des caractéristiques d'un signal de contrôle sont détectées en continu pour définir un vecteur de réveil. Le réveil de l'ordinateur est décidé sur la base du vecteur de réveil et d'une liste ordonnée de différents motifs du signal de contrôle

DE 10 2011 107055 A1 divulgue procédé d'estimation de l'état de charge d'une batterie électrique d'un véhicule électrifié mis en œuvre dans un système de recharge électrique où un serveur et ledit véhicule électrifié sont en communication de données, ledit procédé comprend, au début d'une session de recharge électrique, une première communication de données dudit véhicule électrifié vers ledit serveur, comprenant des données de session de recharge électrique incluant des données d'identification de véhicule, un premier état de charge effectif, de ladite batterie électrique, un état de santé de ladite batterie électrique et un mode de recharge.

Il est souhaitable de proposer un procédé ne présentant pas les inconvénients susmentionnés de la technique antérieure, pour estimer l'état de charge d'une batterie électrique d'un véhicule électrifié et pour fournir cette information sans sollicitation exagérée des équipements électroniques embarqués du véhicule. Selon un premier aspect, l'invention concerne un procédé d'estimation de l'état de charge d'une batterie électrique d'un véhicule électrifié mis en œuvre dans un système de recharge électrique de véhicules électrifiés comprenant des moyens de recharge électrique reliés à un réseau d'alimentation électrique et assurant une recharge électrique de la batterie électrique, au moins un premier serveur informatique hébergeant un système logiciel de gestion de véhicules connectés et un réseau étendu de communication de données à travers lequel le véhicule électrifié et le premier serveur informatique sont en communication de données.

Conformément à l'invention, le procédé comprend, au début d'une session de recharge électrique à un instant $t_0$, une première communication de données du véhicule électrifié vers le premier serveur informatique, cette première communication de données comprenant des données de session de recharge électrique incluant des données d'identification de véhicule, un premier état de charge effectif de la batterie électrique, un état de santé de la batterie électrique et un mode de recharge, et, pendant la session de recharge électrique, une estimation et une fourniture par le premier serveur informatique d'un état de charge estimé, l'état de charge estimé étant déterminé à partir des données de session de recharge électrique, d'une capacité énergétique de la batterie électrique et d'un premier facteur de calcul d'estimation, le premier facteur de calcul d'estimation étant déterminé par sélection dans une base de données de facteurs de calcul d'estimation accessible au premier serveur informatique et à partir des données de session de recharge électrique.

Selon une caractéristique particulière, le procédé comprend une détermination du premier facteur de calcul d'estimation à l'aide d'un module d'intelligence artificielle.

Selon une autre caractéristique particulière, le procédé comprend, au cours de la session de recharge électrique, une deuxième communication de données du véhicule électrifié vers le premier serveur informatique, à un instant $t_{R1}$, cette deuxième communication de données comprenant un deuxième état de charge effectif de la batterie électrique, et une correction intermédiaire de l'état de charge estimé à partir du deuxième état de charge effectif et une détermination par calcul d'un deuxième facteur de calcul d'estimation à partir du deuxième état de charge effectif selon une fonction de calcul F3 suivante :

$$(F3)\ \alpha_{R1} = 1 - \frac{SOC_E(t_{R1}) - SOC_{R1}(t_{R1})}{SOC_E(t_{R1}) - SOC_0(t_0)}$$

Où :

- $SOC_{R1}$ est le deuxième état de charge effectif
- $SOC_E$ état de charge estimé,
- $\alpha_{R1}$ est le deuxième facteur de calcul d'estimation,
- $SOC_0$ est le premier état de charge effectif,

le premier facteur de calcul d'estimation étant remplacé par le deuxième facteur de calcul d'estimation pour des déterminations ultérieures de l'état de charge estimé pendant la session de recharge électrique.

Selon encore une autre caractéristique particulière, le procédé comprend, à la fin de la session de recharge électrique à un instant $t_{R2}$, une autre communication de données du véhicule électrifié vers le premier serveur informatique, cette autre communication de données comprenant un troisième état de charge effectif de la batterie électrique, et une correction finale de l'état de charge estimé à partir du troisième état de charge effectif, une détermination par calcul d'un troisième facteur de calcul d'estimation à partir du deuxième état de charge effectif selon une fonction F3 de calcul suivante :

$$(F3)\ \alpha_{R2} = 1 - \frac{SOC_E(t_{R2}) - SOC_{R2}(t_{R2})}{SOC_E(t_{R2}) - SOC_0(t_0)}$$

où :

- $\alpha_{R2}$ est le troisième facteur de calcul d'estimation,
- $SOC_{R2}$ est le troisième état de charge effectif,
- $SOC_E$ état de charge estimé,

et un enregistrement du troisième facteur de calcul d'estimation dans la base de données de facteurs de calcul d'estimation.

Selon encore une autre caractéristique particulière, lorsque le mode de recharge inclut une consigne de recharge électrique à puissance constante, l'état de charge estimé est déterminé à l'aide :

- d'une première cartographie donnant un état énergétique en fonction d'un état de charge de ladite batterie électrique et inversement,
- et d'une première fonction de calcul F1 donnant un état énergétique estimé, selon une fonction de calcul F1 suivante :

$$(F1)\ SOE(t) = SOE(t0 + dt) =$$
$$SOE_0(t0) + \alpha_E \frac{\int_{t0}^{t} PC.dt}{SOH * E * 3600}$$

où :

- PC et SOH représentent la consigne de recharge à puissance constante et l'état de santé de la batterie électrique,
- E représente la capacité énergétique nominale de la batterie électrique en kWh, et le nombre 3600 réalise la conversion entre l'unité de temps « heure » de la capacité E et l'unité de temps « seconde » de la variable de temps t.
- $\alpha_E$ est le facteur de calcul d'estimation dont la valeur est initialement celle du premier facteur de calcul d'estimation,

cet état énergétique estimé à partir duquel est déterminé ledit état de charge estimé via la première cartographie.

Selon encore une autre caractéristique particulière, lorsque le mode de recharge inclut une consigne de recharge électrique à profil de courant, l'état de charge estimé est déterminé à l'aide d'une deuxième cartographie entre état de charge et courant de recharge, d'une troisième cartographie définissant un profil temporel de courant de recharge, et d'une deuxième fonction de calcul donnant l'état de charge estimé.

Selon encore une autre caractéristique particulière, le procédé comprend une fourniture de l'état de charge estimé à un deuxième serveur informatique hébergeant un système logiciel de gestion énergétique du réseau d'alimentation électrique, le deuxième serveur informatique étant en communication de données avec le premier serveur informatique à travers le réseau étendu de communication de données.

Selon encore une autre caractéristique particulière, le procédé comprend une fourniture de l'état de charge estimé à un dispositif informatique d'un utilisateur du véhicule électrifié, le dispositif informatique étant en communication de données avec le premier serveur informatique à travers le réseau étendu de communication de données.

Selon encore une autre caractéristique particulière, le dispositif informatique est un téléphone intelligent dit smartphone.

L'invention concerne aussi un serveur informatique comportant un dispositif de stockage de données stockant des instructions de programme pour la mise en œuvre du procédé tel que décrit brièvement ci-dessus.

D'autres avantages et caractéristiques de la présente invention apparaîtront plus clairement à la lecture de la description détaillée ci-dessous de plusieurs modes de réalisation particuliers de l'invention, en référence aux dessins annexés, dans lesquels :

[Fig.1] La Fig.1 montre un chronogramme simplifié relatif à des opérations de réveil/endormissement dans un système de recharge électrique de véhicules électrifiés de la technique antérieure.

[Fig.2] La Fig.2 est un bloc-diagramme général relatif à la mise en œuvre du procédé selon l'invention dans un système de recharge électrique de véhicules électrifiés.

[Fig.3] La Fig.3 montre un exemple d'une courbe de recharge avec profil de puissance d'un mode de recharge dit « Mode 2 ».

[Fig.4] La Fig.4 montre un chronogramme simplifié relatif à des opérations de réveil/endormissement dans un système de recharge électrique de véhicules électrifiés mettant en œuvre le procédé selon l'invention.

[Fig.5] La Fig.5 est un logigramme montrant des blocs fonctionnels relatifs au procédé selon l'invention.

[Fig.6] La Fig.6 montre de manière schématique le calcul de l'état de charge estimé dans le cas d'une consigne de recharge électrique à puissance constante.

[Fig.7] La Fig.7 montre de manière schématique le calcul de l'état de charge estimé dans le cas d'une consigne de recharge électrique à profil de courant.

[Fig.8] La Fig.8 montre de manière schématique des corrections en boucle fermée réalisées sur le calcul de l'état de charge estimé.

[Fig.9] La Fig.9 montre une courbe de conversion entre la tension de circuit ouvert aux bornes de la batterie électrique et l'état de charge de celle-ci.

Le procédé selon l'invention est décrit ici dans le contexte d'un système de recharge électrique de véhicules électrifiés basé sur une recharge statique filaire à travers un parc de bornes de recharge électrique. L'invention n'est pas limitée à cette architecture de système de recharge électrique de véhicules électrifiés et pourra être mise en œuvre dans d'autres types de systèmes comme ceux basés sur une recharge par induction statique ou dynamique.

Dans le système de recharge électrique de la Fig.2, repéré SRE, un véhicule électrifié VE est relié à une borne de recharge électrique BRE par un câble électrique CE, à travers une prise de recharge PR. La borne de recharge électrique BRE est reliée à un réseau d'alimentation électrique RE et fait partie d'un parc géré par un fournisseur de service de recharge électrique.

Le véhicule électrifié VE est un véhicule connecté par liaison radio à un réseau étendu de communication de données, tel que le réseau Internet, et comprend notamment une batterie électrique de traction BAT à haute tension et un convertisseur électrique embarqué OBC de type courant alternatif/courant continu dit « AC/DC ». Des contacteurs haute tension CT sont prévus pour la connexion/déconnexion de la batterie électrique avec le convertisseur OBC et le circuit électrique de puissance du véhicule.

La gestion de la batterie électrique BAT est assurée par un module de gestion de batterie électrique BMS relié à un réseau CAN de communication de données du véhicule électrifié VE. Le module de gestion de batterie électrique BMS est associé à des capteurs de courant et de tension (non représentés) et est capable de fournir des données relatives à la batterie électrique BAT, comme son état de charge « SOC » (pour « State Of Charge » en anglais), son état de santé SOH (pour « State Of Health » en anglais) et sa tension de circuit ouvert OCV (pour « Open Circuit Voltage » en anglais). D'autres composants d'électronique embarquée comme un module télématique BTA, une antenne intelligente BSRF, un module superviseur de véhicule VSM et une unité de contrôle de véhicule VCU sont également visibles à la Fig.2 et sont reliés au réseau CAN.

Le système de recharge électrique SRE fait appel également pour son fonctionnement au réseau étendu de communication de données susmentionné, tel que le réseau Internet, et à des systèmes informatiques hébergés dans des nuages de serveurs NS1 à NS3. Le système de recharge électrique SRE utilise des ressources logicielles et matérielles disponibles dans ces nuages de serveurs NS1 à NS3.

Le nuage de serveurs NS1 héberge un système logiciel de gestion de véhicules connectés SWC, par exemple du constructeur automobile du véhicule électrifié VE, assurant plusieurs services de connectivité et de traitement de données d'un parc de véhicules connectés. Le système logiciel de gestion de véhicules connectés SWC est hébergé dans un ou plusieurs serveurs informatiques SRC du nuage NS1.

Le serveur informatique SRC comprend notamment un processeur PROC qui communique avec un dispositif de stockage de données HD, et des dispositifs matériels conventionnels tels que des interfaces réseau NI et autres dispositifs (non représentés). Le processeur PROC comprend une ou plusieurs unités centrales de traitement de données (non représentées) et des mémoires volatiles et non-volatiles (non représentées) pour l'exécution de programmes informatiques.

Comme visible à la Fig.2, le système logiciel de gestion de véhicules connectés SWC comprend un module logiciel MLE dédié à la mise en œuvre du procédé selon l'invention pour l'estimation de l'état de charge de la batterie électrique de traction BAT. Le procédé selon l'invention est mis en œuvre notamment par l'exécution par le processeur PROC d'instructions de code du module logiciel MLE.

Le véhicule électrifié VE est relié au système logiciel de gestion de véhicules connectés SWC et au module logiciel MLE par une liaison radio de communication de données LR1, typiquement à travers un réseau de radiotéléphonie cellulaire en mode « 3G », « 4G » ou « 5G », par exemple.

L'utilisateur USER du véhicule électrifié VE, à travers une application logicielle dédiée installée sur son dispositif informatique SP, tel que smartphone, communique avec un service de consultation du système logiciel de gestion de véhicules connectés SWC. Le smartphone SP est relié au système SWC et au module logiciel MLE par une liaison radio de communication de données LR2 typiquement à travers le réseau de radiotéléphonie cellulaire susmentionné. L'utilisateur USER a la possibilité de suivre la recharge de la batterie électrique BAT de son véhicule.

Le nuage de serveurs NS2 héberge un système logiciel de gestion énergétique EMS. Le système EMS a à charge la gestion d'une recharge intelligente de la batterie électrique BAT dans le cadre d'un réseau de transport d'énergie électrique de type « Smart Grid ». Le système EMS est en communication avec le système logiciel de gestion de véhicules connectés SWC à travers une liaison de communication de données LR3.

Le nuage de serveurs NS3 héberge un système logiciel UTP du fournisseur de service de recharge électrique qui exploite le parc de bornes de recharge électrique dont fait partie la borne BRE. Le système logiciel de fournisseur de service de recharge électrique UTP est en communication avec le système logiciel de gestion énergétique EMS à travers une liaison de communication de données LR4.

Dans le véhicule électrifié VE, la détection du branchement du câble électrique de recharge CE provoque la transmission de données de session de recharge électrique DSC vers le nuage de serveurs NS1. Les données de session de recharge électrique DSC comprennent notamment un identificateur de véhicule / utilisateur VE/USER, un mode de recharge MC préconisé pour le véhicule, un état de charge initial $SOC_0$ et l'état de santé SOH de la batterie électrique BAT. L'état de charge initial $SOC_0$ et l'état de santé SOH de la batterie électrique BAT sont ceux indiqués à ce moment-là par le module de gestion de batterie électrique BMS.

En variante, le mode de recharge MC préconisé pour le véhicule pourra être récupéré dans une base de données par le système logiciel de gestion de véhicules connectés SWC et/ou le module logiciel MLE à partir de l'identificateur de véhicule / utilisateur VE/USER.

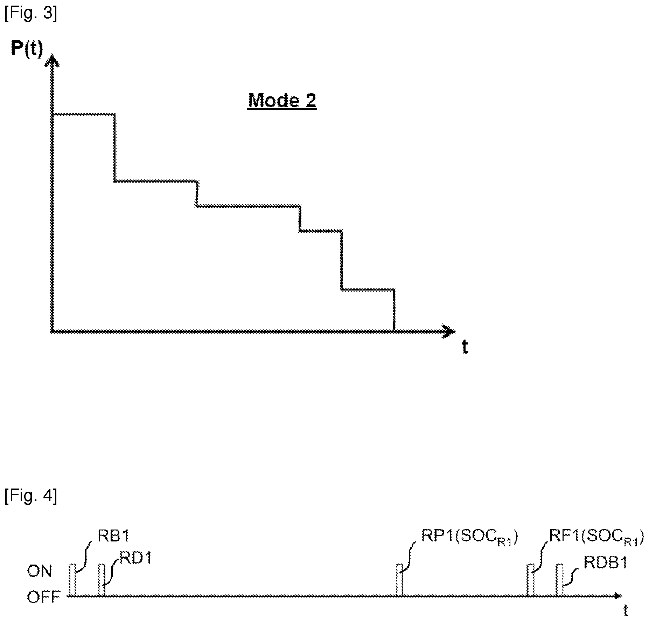

Le tableau 1 ci-dessous montre différents modes de recharge disponibles, à savoir, à puissance constante, avec profil de puissance P(t) ou avec profil de courant I(t). Une courbe de recharge avec profil de puissance P(t) du mode de recharge dit « Mode 2 » est montrée à titre d'exemple à la Fig.3.

[Tableau 1]

| Mode de recharge MC | Puissance de recharge |
|---|---|
| Mode 2 | 1,8-3,2 kW, P(t), I(t) |
| Mode 3 | 7,3 kW, P(t), I(t) |
| Mode 3 | 22 kW, P(t), I(t) |
| Mode 4 | 50 kW, P(t), I(t) |
| Mode 4 | 150 kW, P(t), I(t) |
| Mode 4 | 350 kW, P(t), I(t) |
| Mode « Smart Grid » | P(t), I(t) |

Conformément à l'invention, les données de session de recharge électrique susmentionnées DSC= (VE/USER, MC, $SOC_0$, SOH) définissent un profil particulier pour la session de recharge électrique. Ces données DSC sont traitées par le module logiciel MLE, notamment par un module d'intelligence artificielle IA associé à celui-ci, de façon à obtenir un facteur de calcul d'estimation $\alpha$ approprié, comme cela apparaîtra plus clairement par la suite. Des données de masse pourront aussi être exploitées par le module d'intelligence artificielle IA, conjointement avec les données DSC, pour déterminer le facteur de calcul d'estimation $\alpha$ approprié.

Une consigne de recharge CRE, qui est une consigne de courant de recharge ou une consigne de puissance de recharge selon le mode de recharge MC, est déterminée suite à des échanges de données entre le système logiciel de gestion de véhicules connectés SWC et le système logiciel de gestion énergétique EMS et est transmise au véhicule électrifié VE. Dans le véhicule électrifié VE, la consigne de recharge CRE est exploitée notamment pour la commande du convertisseur OBC et la gestion assurée par le module BMS.

Le système logiciel de gestion énergétique EMS échange des données avec le système logiciel de fournisseur de service de recharge électrique UTP pour établir et gérer le déroulement de la session de recharge électrique. La borne de recharge électrique BRE est pilotée par le système logiciel de fournisseur de service de recharge électrique UTP pour recharger la batterie électrique BAT selon le mode de recharge MC approprié.

Conformément à l'invention, pendant le déroulement de la session de recharge électrique, c'est un état de charge $SOC_E$ estimé, déterminé par le module logiciel MLE, qui est fourni au système logiciel de gestion énergétique EMS pour sa gestion intelligente de la recharge et à l'application logicielle dédiée hébergée dans le smartphone SP de l'utilisateur USER à chaque sollicitation de ceux-ci. L'invention permet ainsi pendant la session de recharge électrique de réduire drastiquement le nombre des opérations de réveil/endormissement des composants d'électronique embarquée concernés du véhicule électrifié VE.

La Fig.4 montre, à titre d'exemple, une séquence d'opérations de réveil/endormissement du module télématique BTA et de l'antenne intelligente BSRF intervenant avec le procédé de l'invention pendant la session de recharge électrique de la batterie électrique BAT. Comme à la Fig.1, les états « ON » et « OFF » représentent respectivement le réveil et l'endormissement de ces équipements. Un seul réveil RP1 intervient entre des réveils de début RD1 et de fin RF1 de la session de recharge électrique. Le branchement du câble électrique de recharge CE sur le véhicule électrifié VE provoque un premier réveil RB1 des équipements. Le débranchement du câble électrique de recharge CE du véhicule provoque un dernier réveil RDB1 des équipements.

Les données de session de recharge électrique DSC= (VE/USER, MC, $SOC_0$, SOH) sont transmises typiquement pendant le premier réveil RB1 au module logiciel MLE. La consigne de recharge CRE est transmise en retour au véhicule électrifié VE lors du réveil de début de session de recharge électrique RD1.

L'unique réveil RP1 pendant la session de recharge électrique correspond à une demande du module logiciel MLE pour une lecture de l'état de charge effectif, désigné $SOC_{R1}$, de la batterie électrique BAT. L'état de charge effectif $SOC_{R1}$ est alors fourni par le module BMS du véhicule et celui-ci est transmis au module logiciel MLE. Cette lecture demandée par le module logiciel MLE de l'état de charge effectif $SOC_{R1}$ en cours de session de recharge électrique n'est pas systématique, mais peut être décidée par le module logiciel MLE pour la précision de l'estimation, de façon à recaler l'état de charge estimé $SOC_E$ sur l'état de charge effectif $SOC_{R1}$ de la batterie électrique BAT et corriger ainsi en boucle fermée une dérive éventuelle de l'estimation $SOC_E$ réalisée par le module logiciel MLE.

Une autre lecture de l'état de charge effectif, désigné $SOC_{R2}$, pourra être demandée au module BMS par le module logiciel MLE à la fin de la session de recharge électrique, typiquement lors du réveil RF1. De même que celle intervenant pendant le réveil RP1, cette lecture de l'état de charge effectif $SOC_{R2}$ permet une correction en boucle fermée par le module logiciel MLE d'une dérive éventuelle de l'estimation $SOC_E$, cette correction étant réalisée ici à la fin de la session de recharge électrique.

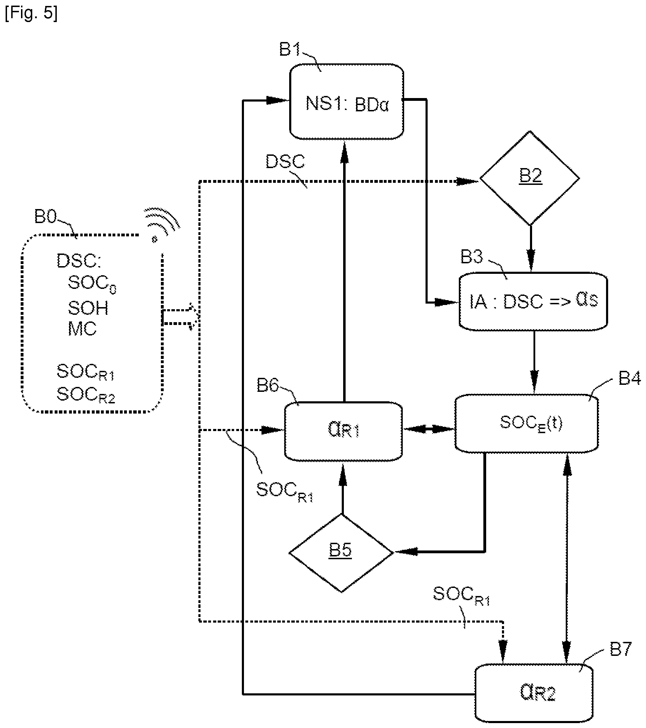

Différentes fonctions du module logiciel MLE, nécessaires pour la mise en œuvre du procédé de l'invention, sont maintenant décrites ci-dessous en référence plus particulièrement aux Figs.5 à 8.

Comme visible dans le logigramme de la Fig.5, le procédé de l'invention fait appel à des blocs fonctionnels B0 à B7.

Le bloc fonctionnel B0 représente la transmission initiale des données de session de recharge électrique DSC et les transmissions ultérieures des états de charge effectifs $SOC_{R1}$, $SOC_{R2}$, du véhicule électrifié VE vers le nuage de serveurs NS1 et le module logiciel MLE.

Le bloc fonctionnel B1 représente le stockage dans une base de données $BD\alpha$ d'un ensemble de facteurs de correction d'estimation $\alpha$. Les facteurs de correction d'estimation $\alpha$ dans la base de données $BD\alpha$ sont triés et affectés aux différents véhicules électrifiés VE et/ou utilisateurs USER gérés par le système logiciel de gestion de véhicules connectés SWC. La base de données $BD\alpha$ est hébergée dans le nuage de serveurs NS1, plus précisément dans le dispositif de stockage de données HD (cf. Fig.2).

Le bloc fonctionnel B2 représente le démarrage d'une session de recharge électrique. Les données de session de recharge électrique DSC sont alors reçues et prises en compte par le processus de traitement du module logiciel MLE.

Le bloc fonctionnel B3 est exécuté ensuite et détermine un facteur de calcul d'estimation $\alpha_S$ approprié pour la session de recharge électrique considérée. Le facteur de calcul d'estimation $\alpha_S$ approprié est déterminé en fonction des données de session de recharge électrique DSC qui définissent un profil particulier pour la session de recharge électrique. Comme indiqué plus haut, le module d'intelligence artificielle IA susmentionné pourra être utilisé pour sélectionner le facteur de calcul d'estimation $\alpha_S$ approprié dans la base de données $BD\alpha$ à partir du profil déduit des données DSC. D'autres méthodes pourront être utilisées, tout en restant dans le cadre de l'invention, pour déterminer le facteur de calcul d'estimation $\alpha_S$ approprié, comme des méthodes d'interpolation, de sélection par similarité et autres.

Le bloc fonctionnel B4 est le calcul en temps réel de l'état de charge estimé $SOC_E(t)$. Le calcul de l'état de charge estimé $SOC_E(t)$ est réalisé de manière différente selon la consigne de recharge CRE qui est disponible et qui dépend du mode de recharge MC.

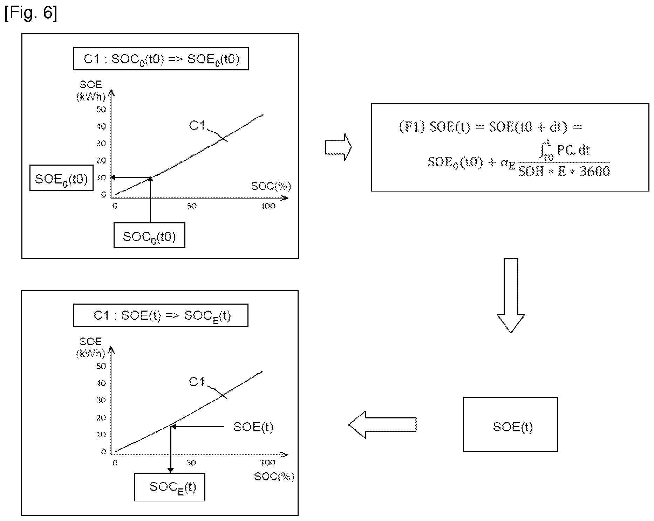

La Fig.6 illustre le calcul de l'état de charge estimé $SOC_E(t)$ dans le cas où la consigne de recharge CRE est une consigne de recharge électrique à puissance constante PC.

L'état de charge $SOC_E(t)$ est estimé à l'aide d'une cartographie C1 et d'une fonction de calcul F1 visibles à la Fig.6. La cartographie C1, représentée par une courbe, donne l'état énergétique SOE (en kWh) de la batterie électrique BAT en fonction de l'état de charge SOC (en %) de celle-ci.

Dans la fonction de calcul F1 :

- PC et SOH représentent la consigne de recharge à puissance constante et l'état de santé de la batterie électrique BAT comme susmentionnés, E représente la capacité énergétique nominale de la batterie électrique BAT en kWh, et le nombre 3600 réalise la conversion entre l'unité de temps « heure » de la capacité E et l'unité de temps « seconde » de la variable de temps t.
- $\alpha_E$ est le facteur de calcul d'estimation dont la valeur est initialement celle $\alpha_S$ déterminée par le bloc fonctionnel B3 (cf. Fig.5) pour la session de recharge électrique considérée.

L'état énergétique $SOE_0$ est d'abord déterminé à l'aide de la cartographie C1 à partir de l'état de charge $SOC_0$ disponible. Une interpolation à partir des valeurs proches de la cartographie C1 est utilisée si cela est nécessaire pour obtenir l'état énergétique $SOE_0$ avec une bonne précision.

La fonction F1 permet d'estimer la valeur de l'état SOE(t) au temp t considéré, avec dt = t-t0.

L'état de charge estimé $SOC_E(t)$ est déterminé à l'aide de la cartographie C1 à partir de l'état SOE(t) obtenu avec la fonction F1. Une interpolation à partir des valeurs proches de la cartographie C1 est utilisée si cela est nécessaire pour obtenir l'état de charge estimé $SOC_E(t)$ avec une bonne précision.

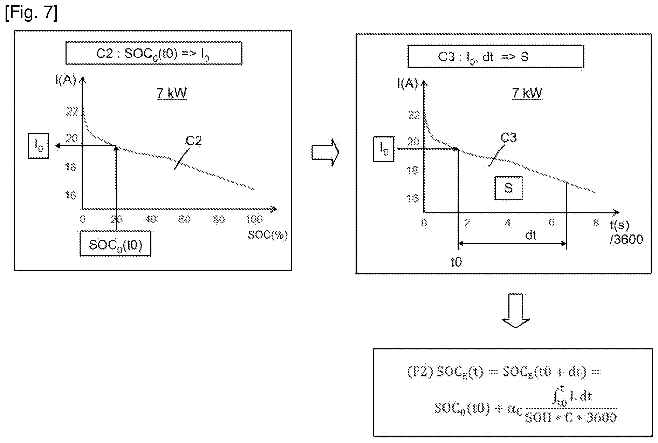

La Fig.7 illustre le calcul de l'état de charge estimé $SOC_E(t)$ dans le cas où la consigne de recharge CRE est une consigne de recharge électrique à profil de courant I(t), par exemple à la puissance de 7 kW.

L'état de charge $SOC_E(t)$ est estimé à l'aide de cartographies C2, C3 et d'une fonction de calcul F2 visibles à la Fig.7. La cartographie C2, représentée par une courbe, donne le courant de recharge I (en A) en fonction de l'état de charge SOC (en %). La cartographie C3, représentée par une courbe, donne le profil de courant I(t) dans le temps pour la recharge de la batterie électrique BAT.

Dans la fonction de calcul F2 :

- I et SOH représentent l'amplitude du courant donnée par la cartographie C3 et l'état de santé de la batterie électrique BAT comme susmentionnés, C représente la capacité énergétique nominale de la batterie électrique BAT en Ah, et le nombre 3600 réalise la conversion entre l'unité de temps « heure » de la capacité C et l'unité de temps « seconde » de la variable de temps t.
- $\alpha_C$ est le facteur de calcul d'estimation dont la valeur est initialement celle $\alpha_S$ déterminée par le bloc fonctionnel B3 (cf. Fig.5) pour la session de recharge électrique considérée.

Un courant initial I0, de début de recharge, est déterminé à l'aide de la cartographie C2 à partir de l'état de charge $SOC_0$ disponible. Une interpolation à partir des valeurs proches de la cartographie C2 est utilisée si cela est nécessaire pour obtenir le courant initial I0 avec une bonne précision.

L'intégrale de la courbe I(t) de la cartographie C3 entre un temps t0, correspondant au courant initial I0, et le temps t considéré est nécessaire pour le calcul de la fonction F2. La surface S dans la courbe I(t) représente la valeur de cette intégrale. Des interpolations à partir des valeurs proches de la cartographie C3 sont utilisées si cela est nécessaire pour obtenir la surface S avec une bonne précision. L'état de charge estimé $SOC_E(t)$ est donnée par la fonction F2.

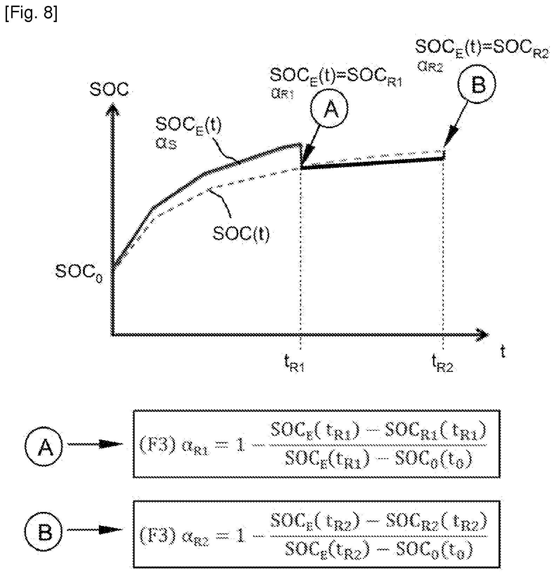

Les mécanismes destinés à corriger en boucle fermée la dérive de l'estimation $SOC_E(t)$ de l'état de charge de la batterie électrique BAT sont maintenant décrits ci-dessous, plus particulièrement en référence aux Figs.5 et 8.

Les blocs fonctionnels B5 et B6 concernent la correction au cours de la session de recharge électrique, susmentionnée en référence à la Fig.4 (cf. RP1). Cette correction intermédiaire est décidée par le bloc fonctionnel B5, par exemple au-delà d'une certaine durée de la session de recharge électrique. Elle donne lieu à une lecture de l'état de charge $SOC_{R1}$ de la batterie électrique BAT qui intervient à un temps $t_{R1}$ (cf. Fig.8).

Le bloc fonctionnel B7 concerne une correction finale à la fin de la session de recharge électrique, susmentionnée en référence à la Fig.4 (cf. RF1). Elle est systématique et donne lieu à une lecture de l'état de charge $SOC_{R2}$ de la batterie électrique BAT qui intervient à un temps $t_{R2}$ (cf. Fig.8).

Une fonction de calcul F3 montrée à la Fig.8 est utilisée pour corriger la valeur du facteur de calcul d'estimation $\alpha$ et faire correspondre celle-ci aux états de charge effectifs $SOC_{R1}$ et $SOC_{R2}$ qui sont lus aux temps $t_{R1}$ et $t_{R2}$, respectivement.

En cours de session de recharge électrique, au temps $t_{R1}$, le facteur de calcul d'estimation $\alpha_{R1}$ est calculé à partir de la valeur de $SOC_E$ avec le facteur $\alpha_S$ (cf. B3) et de $SOC_{R1}$. Le facteur $\alpha_{R1}$ est utilisé par le bloc fonctionnel B4 pour la suite du calcul de l'état de charge estimé $SOC_E(t)$. Le facteur $\alpha_{R1}$ est transmis au bloc fonctionnel B1 pour enrichir la base de données $BD\alpha$.

Le point A à la Fig.8 correspond au recalage de l'état de charge estimé $SOC_E(t)$ sur l'état de charge effectif SOC(t) =$SOC_{R1}$, l'état de charge SOC(t) étant montré en trait interrompu à la Fig.8.

A la fin de la session de recharge électrique, au temps $t_{R2}$, le facteur de calcul d'estimation $\alpha_{R2}$ est calculé à partir de la valeur de $SOC_E$ avec le facteur $\alpha_{R1}$ (ou $\alpha_S$ si la correction intermédiaire ci-dessus n'a pas été effectuée) et de $SOC_{R2}$. Le facteur $\alpha_{R2}$ est transmis au bloc fonctionnel B1 pour enrichir la base de données $BD\alpha$. Typiquement, l'état de charge $SOC_E(t)$= $SOC_{R2}$ est transmis en fin de session de recharge électrique au système logiciel de gestion énergétique EMS.

Le point B à la Fig.8 correspond au recalage de l'état de charge estimé $SOC_E(t)$ sur l'état de charge effectif SOC(t) =$SOC_{R2}$ à la fin de la session de recharge électrique.

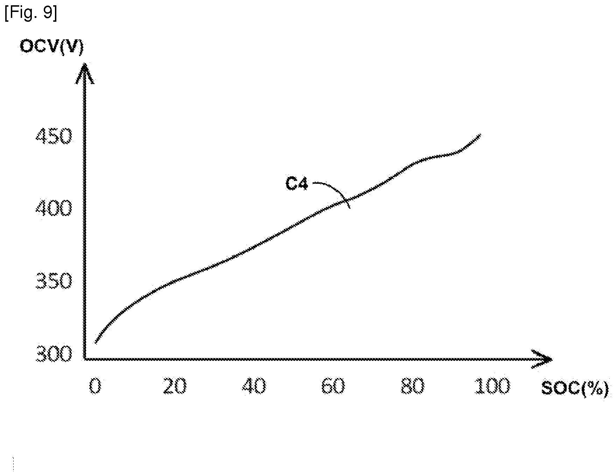

Dans certaines applications, pour diverses raisons, c'est une tension de circuit ouvert OCV aux bornes de la batterie électrique BAT qui pourra être transmise par le véhicule électrifié VE au module logiciel d'estimation d'état de charge MLE à la place de l'état de charge SOC. Dans un tel cas, une cartographie C4, montrée à la Fig.9 sous la forme d'une courbe, pourra être utilisée par le module logiciel MLE pour obtenir l'état de charge effectif SOC à partir de la tension de circuit ouvert OCV. Le procédé de l'invention comme décrit plus haut pour ainsi être utilisé dans ces applications pour obtenir l'état de charge estimé $SOC_E$.

L'invention ne se limite pas aux modes de réalisation particuliers qui ont été décrits ici à titre d'exemple. L'homme du métier, selon les applications de l'invention, pourra apporter différentes modifications entrant dans le champ de protection de l'invention.

**Revendications**

1. Procédé d'estimation de l'état de charge d'une batterie électrique (BAT) d'un véhicule électrifié (VE) mis en œuvre dans un système de recharge électrique de véhicules électrifiés (SRE) comprenant des moyens de recharge électrique (BRE) reliés à un réseau d'alimentation électrique (RE) et assurant une recharge électrique de ladite batterie électrique (BAT), au moins un premier serveur informatique (NS1, SRC) hébergeant un système logiciel de gestion de véhicules connectés (SWC) et un réseau étendu de communication de données à travers lequel ledit véhicule électrifié (VE) et ledit premier serveur informatique (NS1, SRC) sont en communication de données (LR1), et où ledit procédé comprend, au début d'une session de recharge électrique à un instant $t_0$, une première communication de données dudit véhicule électrifié (VE) vers ledit premier serveur informatique (NS1, SRC), ladite première communication de données comprenant des données de session de recharge électrique (DSC) incluant des données d'identification de véhicule (VE/USER), un premier état de charge effectif ($SOC_0$), de ladite batterie électrique (BAT), un état de santé (SOH) de ladite batterie électrique (BAT) et un mode de recharge (MC) ; et **caractérisé en ce que**: pendant ladite session de recharge électrique, une estimation et une fourniture par ledit premier serveur informatique (NS1, SRC) d'un état de charge estimé ($SOC_E$), ledit état de charge estimé ($SOC_E$) étant déterminé à partir desdites données de session de recharge électrique (DSC), d'une capacité énergétique (C, E) de ladite batterie électrique (BAT) et d'un premier facteur de calcul d'estimation ($\alpha_S$), ledit premier facteur de calcul d'estimation ($\alpha_S$) étant déterminé par sélection dans une base de données de facteurs de calcul d'estimation (DB$\alpha$) accessible audit premier serveur informatique (NS1, SRC) et à partir desdites données de session de recharge électrique (DSC).

2. Procédé selon la revendication 1, **caractérisé en ce qu'**il comprend une détermination dudit premier facteur de calcul d'estimation ($\alpha_S$) à l'aide d'un module d'intelligence artificielle (IA).

3. Procédé selon la revendication 1 ou 2, **caractérisé en ce qu'**il comprend, au cours de ladite session de recharge électrique, une deuxième communication de données dudit véhicule électrifié (VE) vers ledit premier serveur informatique (NS1, SRC), à un instant $t_{R1}$, ladite deuxième communication de données comprenant un deuxième état de charge effectif ($SOC_{R1}$) de ladite batterie électrique (BAT), et une correction intermédiaire dudit état de charge estimé ($SOC_E$) à partir dudit deuxième état de charge effectif ($SOC_{R1}$) et une détermination par calcul d'un deuxième facteur de calcul d'estimation ($\alpha_{R1}$) à partir dudit deuxième état de charge effectif ($SOC_{R1}$) selon une fonction de calcul (F3) suivante :

$$(F3)\ \alpha_{R1} = 1 - \frac{SOC_E(t_{R1}) - SOC_{R1}(t_{R1})}{SOC_E(t_{R1}) - SOC_0(t_0)}$$

, ledit premier facteur de calcul d'estimation ($\alpha_S$) étant remplacé par ledit deuxième facteur de calcul d'estimation ($\alpha_{R1}$) pour des déterminations ultérieures dudit état de charge estimé ($SOC_E$) pendant ladite session de recharge électrique.

4. Procédé selon l'une quelconque des revendications 1 à 3, **caractérisé en ce qu'**il comprend, à la fin de ladite session de recharge électrique à un instant $t_{R2}$, une autre communication de données dudit véhicule électrifié (VE) vers ledit premier serveur informatique (NS1, SRC), ladite autre communication de données comprenant un troisième état de charge effectif ($SOC_{R2}$) de ladite batterie électrique (BAT), et une correction finale dudit état de charge estimé ($SOC_E$) à partir dudit troisième état de charge effectif ($SOC_{R2}$), une détermination par calcul d'un troisième facteur de calcul d'estimation ($\alpha_{R2}$) à partir dudit deuxième état de charge effectif ($SOC_{R1}$) selon une fonction de calcul (F3) suivante :

$$(F3)\ \alpha_{R2} = 1 - \frac{SOC_E(t_{R2}) - SOC_{R2}(t_{R2})}{SOC_E(t_{R2}) - SOC_0(t_0)}$$

, et un enregistrement dudit troisième facteur de calcul d'estimation ($\alpha_{R2}$) dans ladite base de données de facteurs de calcul d'estimation (DB$\alpha$).

5. Procédé selon l'une quelconque des revendications 1 à 4, ledit mode de recharge (MC) incluant une consigne de recharge électrique à puissance constante (PC), **caractérisé en ce que** ledit état de charge estimé ($SOC_E$) est déterminé à l'aide :

- d'une première cartographie (C1) donnant un état énergétique en fonction d'un état de charge de ladite batterie électrique (BAT) et inversement,
- et d'une première fonction de calcul (F1) donnant un état énergétique estimé (SOE), cette fonction de calcul (F1) étant la suivante :

$$(F1)\ SOE(t) = SOE(t0 + dt) =$$

$$SOE_0(t0) + \alpha_E \frac{\int_{t0}^{t} PC.dt}{SOH * E * 3600}$$

où :

- PC et SOH représentent la consigne de recharge à puissance constante et l'état de santé de la batterie électrique BAT,
- E représente la capacité énergétique nominale de la batterie électrique BAT en kWh, et le nombre 3600 réalise la conversion entre l'unité de temps « heure » de la capacité E et l'unité de temps « seconde » de la variable de temps t.
- $\alpha_E$ est le facteur de calcul d'estimation dont la valeur est initialement celle du premier facteur de calcul d'estimation $\alpha_S$,

cet état énergétique estimé (SOE) à partir duquel est déterminé ledit état de charge estimé ($SOC_E$) via la première cartographie (C1).

6. Procédé selon l'une quelconque des revendications 1 à 4, ledit mode de recharge incluant une consigne de recharge électrique à profil de courant (I(t)), **caractérisé en ce que** ledit état de charge estimé ($SOC_E$) est déterminé à l'aide d'une deuxième cartographie entre état de charge et courant de recharge (C2), d'une troisième cartographie (C3) définissant un profil temporel de courant de recharge (I(t)), et d'une deuxième fonction de calcul (F2) donnant ledit état de charge estimé ($SOC_E$).

7. Procédé selon l'une quelconque des revendications 1 à 6, **caractérisé en ce qu'**il comprend une fourniture dudit état de charge estimé ($SOC_E$) à un deuxième serveur informatique (NS2) hébergeant un système logiciel de gestion énergétique (EMS) dudit réseau d'alimentation électrique (RE), ledit deuxième serveur informatique (NS2) étant en communication de données avec ledit premier serveur informatique (NS1, SRC) à travers ledit réseau étendu de communication de données.

8. Procédé selon l'une quelconque des revendications 1 à 7, **caractérisé en ce qu'**il comprend une fourniture dudit état de charge estimé ($SOC_E$) à un dispositif informatique (SP) d'un utilisateur (USER) dudit véhicule électrifié (VE), ledit dispositif informatique (SP) étant en communication de données avec ledit premier serveur informatique (NS1, SRC) à travers ledit réseau étendu de communication de données.

9. Procédé selon la revendication 8, **caractérisé en ce que** ledit dispositif informatique est un téléphone intelligent dit smartphone (SP).

10. Serveur informatique (NS1, SRC) comportant un dispositif de stockage de données (HD) stockant des instructions de programme (MLE) pour la mise en œuvre du procédé selon l'une quelconque des revendications 1 à 9.

**Patentansprüche**

1. Verfahren zur Schätzung des Ladezustands einer elektrischen Batterie (BAT) eines elektrifizierten Fahrzeugs (EV), implementiert in einem elektrischen Ladesystem für elektrifizierte Fahrzeuge (SRE), umfassend elektrische Lademittel (BRE), die an ein elektrisches Versorgungsnetz (RE) angeschlossen sind und Sicherstellen der elektrischen Wiederaufladung der elektrischen Batterie (BAT), mindestens einen ersten Computerserver (NS1, SRC), der ein Softwaresystem (SWC) für das verbundene Fahrzeugmanagement und einen Netzwerkdatenkommunikationsbereich hostet, über den das elektrifizierte Fahrzeug (EV) und der erste Computer kommunizieren Server (NS1, SRC) befinden sich in der Datenkommunikation (LR1) und wo das Verfahren umfasst zu Beginn einer elektrischen Ladesitzung zu einem Zeitpunkt t ₀ eine erste Datenkommunikation von dem elektrifizierten Fahrzeug (EV) an den ersten Computerserver (NS1, SRC), wobei die erste Datenkommunikation Daten von der elektrischen Ladesitzung umfasst (DSC) einschließlich Fahrzeugidentifikationsdaten (VE/USER), eines ersten effektiven Ladezustands ($S0C_0$) der elektrischen Batterie (BAT), eines Gesundheitszustands (SOH) der elektrischen Batterie (BAT) und eines Ladevorgangs Modus (MC); und **dadurch gekennzeichnet, dass**:

während der elektrischen Ladesitzung eine Schätzung und a Bereitstellung eines Ladezustands durch den ersten Computerserver (NS1, SRC). geschätzt ($SOC_E$), wobei der geschätzte Ladezustand ($SOC_E$) aus den Daten der elektrischen Ladesitzung (DSC), einer Energiekapazität (C, E) der elektrischen Batterie (BAT) und einem ersten Schätzberechnungsfaktor ($\alpha_s$) bestimmt wird. , wobei der erste Schätzberechnungsfaktor ($\alpha_s$) durch Auswahl aus einer Datenbank von Schätzberechnungsfaktoren (DB $\alpha$), auf die der erste Computerserver (NS1, SRC) zugreifen kann, und aus den Daten der elektrischen Ladesitzung (DSC) bestimmt wird.

2. Verfahren nach Anspruch 1, **dadurch gekennzeichnet, dass** es eine Bestimmung des ersten Schätzberechnungsfaktors ($\alpha_s$) unter Verwendung von a umfasst Modul Künstliche Intelligenz (KI).

3. Verfahren nach Anspruch 1 oder 2, **dadurch gekennzeichnet, dass** es während des elektrischen Ladevorgangs eine zweite Datenübertragung von dem elektrifizierten Fahrzeug (EV) an den ersten Computerserver (NS1, SRC) zu einem Zeitpunkt $t_{Ri}$ umfasst zweite Datenkommunikation, die einen zweiten effektiven Ladezustand ($SOC_{R1}$) der elektrischen Batterie (BAT) und eine Zwischenkorrektur des geschätzten Ladezustands ($SOC_E$) aus dem zweiten effektiven Ladezustand ($SOC_{R1}$) und eine Bestimmung umfasst durch Berechnung eines zweiten Schätzberechnungsfaktors ($\alpha_{R1}$) aus dem zweiten effektiven Ladezustand ($SOC_{R1}$) gemäß einer Funktion von Berechnung (F3) folgende:

$$(F3)\alpha_{R1} = 1 - \frac{SOC_E(t_{R1}) - SOC_{R1}((t_{R1})}{SOC_E(t_{R1}) - SOC_0((t_0)}$$

wobei der erste Schätzberechnungsfaktor ($\alpha_s$) durch diesen ersetzt wird zweiten Schätzberechnungsfaktor ($\alpha_{R1}$) für nachfolgende Bestimmungen des geschätzten Ladezustands ($SOC_E$) während der elektrischen Ladesitzung.

4. Verfahren nach einem der Ansprüche 1 bis 3, **dadurch gekennzeichnet, dass** es am Ende des elektrischen Aufladevorgangs zu einem Zeitpunkt $t_{R2}$ eine weitere Datenübertragung von dem elektrifizierten Fahrzeug (EV) an den ersten Servercomputer (NS1, SRC), wobei die andere Datenkommunikation einen dritten effektiven Ladezustand ($SOC_{R2}$) der elektrischen Batterie (BAT) und eine abschließende Korrektur des geschätzten Ladezustands ($SOC_E$) aus dem dritten effektiven Ladezustand ($SOC_{R2}$), eine Bestimmung durch Berechnung eines dritten Schätzberechnungsfaktors ($\alpha_{R2}$) aus dem zweiten effektiven Ladezustand ($SOC_{R1}$) gemäß einer Funktion von Berechnung (F3) :

$$(F3)\alpha_{R2} = 1 - \frac{SOC_E(t_{R2}) - SOC_{R2}((t_{R2})}{SOC_E(t_{R2}) - SOC_0((t_0)}$$

und eine Aufzeichnung des dritten Schätzberechnungsfaktors ($\alpha_{R2}$) in besagte Datenbank mit Schätzungsberechnungsfaktoren (DB $\alpha$).

5. Verfahren nach einem der Ansprüche 1 bis 4, wobei der Lademodus (MC) einen elektrischen Ladesollwert (PC) mit konstanter Leistung umfasst, **dadurch gekennzeichnet, dass** der geschätzte Ladezustand ($SOC_E$) mit Hilfe von bestimmt wird:

- eine erste Karte (C1), die einen Energiezustand als Funktion eines Ladezustands der elektrischen Batterie (BAT) angibt und umgekehrt,
- und eine erste Berechnungsfunktion (F1), die einen geschätzten Energiezustand (SOE) liefert, wobei diese Berechnungsfunktion (F1) wie folgt lautet:

$$(F1)\ SOE(t) + SOE(t0 + dt) =$$

$$SOE_0(t0) + \alpha_E \frac{\int_{t0}^{t} PC.dt}{SOH * E * 3600}$$

Oder:

- PC und SOH stellen den Ladesollwert bei konstanter Leistung und den Gesundheitszustand der BAT-Elektrobatterie dar.

- - E stellt die Nennenergiekapazität der BAT-Elektrobatterie in kWh dar und die Zahl 3600 wandelt zwischen der Zeiteinheit um " Stunde " der Kapazität E und die Zeiteinheit "Sekunde" der Zeitvariablen t.

- $\alpha_E$ ist der Schätzberechnungsfaktor, dessen Wert zunächst dem von entspricht erster Schätzungsberechnungsfaktor $\alpha_s$,

dieser geschätzte Energiezustand (SOE), aus dem dieser Energiezustand bestimmt wird geschätzte Last (SOC$_E$) über die erste Abbildung (C1).

6. Verfahren nach einem der Ansprüche 1 bis 4, wobei der Lademodus einen elektrischen Ladesollwert mit Stromverlauf (I(t)) umfasst,
gekennzeichnet , dass der geschätzte Ladezustand (SOC$_E$) unter Verwendung einer zweiten Abbildung zwischen Ladezustand und Wiederaufladestrom (C2), einer dritten Abbildung (C3), die ein zeitliches Aufladestromprofil (I(t)) definiert, und a zweite Berechnungsfunktion (F2), die den geschätzten Ladezustand (SOC$_E$) angibt.

7. Verfahren nach einem der Ansprüche 1 bis 6, **dadurch gekennzeichnet, dass** es eine Lieferung des geschätzten Ladezustands (SOC$_E$) an einen zweiten Computerserver (NS2) umfasst, der ein Energiemanagement-Softwaresystem (EMS) der Netzwerkstromversorgung hostet (RE), wobei der zweite Computerserver (NS2) über das erweiterte Datenkommunikationsnetzwerk in Datenkommunikation mit dem ersten Computerserver (NS1, SRC) steht.

8. Verfahren nach einem der Ansprüche 1 bis 7, **dadurch gekennzeichnet, dass** es die Bereitstellung des geschätzten Ladezustands (SOC$_E$) an ein Gerät umfasst Computergerät (SP) eines Benutzers (USER) des elektrifizierten Fahrzeugs (EV), wobei das Computergerät (SP) über das erweiterte Datenkommunikationsnetzwerk in Datenkommunikation mit dem ersten Computerserver (NS1, SRC) steht.

9. Verfahren nach Anspruch 8, **dadurch gekennzeichnet, dass** die Vorrichtung Computer ist ein Smartphone, das Smartphone (SP) genannt wird.

10. Computerserver (NS1, SRC), der ein Datenspeichergerät (HD) umfasst, das Programmanweisungen (MLE) zur Implementierung des Verfahrens nach einem der Ansprüche 1 bis 9 speichert.

**Claims**

1. Method for estimating the state of charge of an electric battery (BAT) of an electrified vehicle (EV) implemented in an electric charging system for electrified vehicles (SRE) comprising electric charging means (BRE) connected to an electrical supply network (RE) and ensuring an electric recharge of said electric battery (BAT), at least a first computer server (NS1, SRC) hosting a software system for managing connected vehicles (SWC) and a wide area data communication network through which said electrified vehicle (EV) and said first computer server

(NS1, SRC) are in data communication (LR1), and where
said method comprises, at the start of an electric charging session at a time $t_o$, a first communication of data from said electrified vehicle (VE) to said first computer server (NS1, SRC), said first communication of data comprising electric charging session data (DSC) including vehicle identification data (VE/USER), a first effective state of charge (S0 C$_0$), of said electric battery (BAT), a state of health (SOH) of said electric battery (BAT) and a charging mode (MC); and **characterized in that** :

during said electric charging session, an estimate and a
provision by said first computer server (NS1, SRC) of a load status estimated (SOC$_E$), said estimated state of charge (SOC$_E$) being determined from said electric charging session data (DSC), an energy capacity (C, E) of said electric battery (BAT) and a first estimation calculation factor ($\alpha_s$), said first estimation calculation factor ($\alpha_s$) being determined by selection from a database of estimation calculation factors (DB$\alpha$) accessible

to said first computer server (NS1, SRC) and from said electric charging session data (DSC).

2. Method according to claim 1, **characterized in that** it comprises a determination of said first estimation calculation factor ($\alpha_s$) using a artificial intelligence (AI) module.

3. Method according to claim 1 or 2, **characterized in that** it comprises, during said electric recharging session, a second communication of data from said electrified vehicle (VE) to said first computer server (NS1, SRC), at a time $t_{Ri}$, said second communication of data comprising a second effective state of charge (SOC$_{R1}$) of said electric battery (BAT), and an intermediate correction of said estimated state of charge (SOC$_E$) from said second effective state of charge (SOC$_{R1}$) and a determination by calculation of a second estimation calculation factor ($\alpha_{R1}$) from said second effective state of charge (SOC$_{R1}$) according to a function of
Calculation (F3) following:

$$(F3)\alpha_{R1} = 1 - \frac{SOC_E(t_{R1}) - SOC_{R1}((t_{R1})}{SOC_E(t_{R1}) - SOC_0((t_0)}$$

said first estimation calculation factor ($\alpha_s$) being replaced by said second estimation calculation factor ($\alpha_{R1}$) for subsequent determinations of said estimated state of charge (SOC$_E$) during said electric charging session.

4. Method according to any one of claims 1 to 3, **characterized in that** it comprises, at the end of said electric recharging session at a time $t_{R2}$, another communication of data from said electrified vehicle (VE) to said first computer server (NS1, SRC), said other communication of data comprising a third effective state of charge (SOC$_{R2}$) of said electric battery (BAT), and a final correction of said estimated state of charge (SOC$_E$) from said third effective state of charge (SOC$_{R2}$), a determination by calculation of a third estimation calculation factor ($\alpha_{R2}$) from said second effective state of charge (SOC$_{R1}$) according to a function of
calculation (F3) following:

$$(F3)\alpha_{R2} = 1 - \frac{SOC_E(t_{R2}) - SOC_{R2}((t_{R2})}{SOC_E(t_{R2}) - SOC_0((t_0)}$$

and a record of said third estimation calculation factor ($\alpha_{R2}$) in said database of estimation calculation factors (DB $\alpha$).

5. Method according to any one of claims 1 to 4, said recharging mode (MC) including a constant power electric recharging instruction (PC), **characterized in that** said estimated state of charge (SOC$_E$) is determined using:

-- of a first mapping (C1) giving an energy state as a function of a state of charge of said electric battery (BAT) and vice versa,
- and a first calculation function (F1) giving an estimated energy state (SOE), this calculation function (F1) being as follows:

$$(F1) \ SOE(t) + SOE( t0 + dt ) =$$

$$SOE_0(t0) + \alpha_E \ \frac{\int_{t0}^{t} PC.dt}{SOH * E * 3600}$$

Or:

- PC and SOH represent the constant power charging setpoint and the state of health of the electric battery BAT,

- - E represents the nominal energy capacity of the electric battery BAT in kWh, and the number 3600 performs the conversion between the unit of time " hour " of the capacity E and the time unit "second" of the time variable t.

- $\alpha_E$ is the estimation calculation factor whose value is initially that of the first estimation calculation factor $\alpha_s$,

this estimated energy state (SOE) from which said state of estimated load (SOC$_E$) via the first mapping (C1).

6. Method according to any one of claims 1 to 4, said recharging mode including an electric recharging instruction with current profile (I(t)),
   **characterized in that** said estimated state of charge (SOC$_E$) is determined using a second mapping between state of charge and recharge current (C2), a third mapping (C3) defining a time profile of recharge current (I(t)), and a second calculation function (F2) giving said estimated state of charge (SOC$_E$).

7. Method according to any one of claims 1 to 6, **characterized in that** it comprises a provision of said estimated state of charge (SOC$_E$) to a second computer server (NS2) hosting an energy management software system (EMS) of said electrical supply network (RE), said second computer server (NS2) being in data communication with said first computer server (NS1, SRC) through said wide area data communication network.

8. Method according to any one of claims 1 to 7, **characterized in that** it comprises a supply of said estimated state of charge (SOC$_E$) to a device computer (SP) of a user (USER) of said electrified vehicle (EV), said computer device (SP) being in data communication with said first computer server (NS1, SRC) through said wide area data communication network.

9. Method according to claim 8, **characterized in that** said device computer is a smart phone called smartphone (SP).

10. Computer server (NS1, SRC) comprising a data storage device (HD) storing program instructions (MLE) for implementing the method according to any one of claims 1 to 9.

[Fig. 1]

[Fig. 2]

[Fig. 3]

$P(t)$

Mode 2

t

[Fig. 4]

RB1

RP1($SOC_{R1}$)  RF1($SOC_{R1}$)

RD1

ON

OFF

RDB1

t

[Fig. 5]

[Fig. 6]

$$(F1)\ SOE(t) = SOE(t0 + dt) = SOE_0(t0) + \alpha_E \frac{\int_{t0}^{t} PC.\,dt}{SOH * E * 3600}$$

SOE(t)

[Fig. 7]

[Fig. 8]

$$(F3) \quad \alpha_{R1} = 1 - \frac{SOC_E(t_{R1}) - SOC_{R1}(t_{R1})}{SOC_E(t_{R1}) - SOC_0(t_0)}$$

$$(F3) \quad \alpha_{R2} = 1 - \frac{SOC_E(t_{R2}) - SOC_{R2}(t_{R2})}{SOC_E(t_{R2}) - SOC_0(t_0)}$$

[Fig. 9]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2005535
- FR 3041782 A1
- DE 102011107055 A1